# EUROPÄISCHE PATENTSCHRIFT

(11) **EP 1 704 642 B1**
(45) Veröffentlichungstag und Bekanntmachung des Hinweises auf die Patenterteilung: **27.08.2008**
(21) Anmeldenummer: 05700817.9
(22) Anmeldetag: 12.01.2005
(51) Int. Cl.: H03K 17/975

(54) **BEDIENEINRICHTUNG MIT EINEM KAPAZITIVEN SENSORELEMENT UND ELEKTROGERÄT MIT EINER SOLCHEN BEDIENEINRICHTUNG**
OPERATING CONTROL COMPRISING A CAPACITIVE SENSOR ELEMENT AND AN ELECTRICAL DEVICE COMPRISING AN OPERATING CONTROL OF THIS TYPE
DISPOSITIF DE COMMANDE COMPORTANT UN ELEMENT DE DETECTION CAPACITIF, ET APPAREIL ELECTRIQUE COMPORTANT CE DISPOSITIF DE COMMANDE

(30) Priorität: 12.01.2004 DE 102004002825
(43) Veröffentlichungstag der Anmeldung: 27.09.2006
(73) Patentinhaber: E.G.O. ELEKTRO-GERÄTEBAU GmbH, D-75038 Oberderdingen (DE)
(72) Erfinder: SCHILLING, Wilfried, 76703 Kraichtal (DE); DORWARTH, Ralf, 75038 Oberderdingen (DE)
(74) Vertreter: Ruff, Michael
(86) Internationale Anmeldenummer: PCT/EP2005/000186
(87) Internationale Veröffentlichungsnummer: WO 2005/067146

(56) Entgegenhaltungen:
- EP-A- 0 225 748
- WO-A-86/06544
- US-A- 4 359 720

## Beschreibung

### Anwendungsgebiet und Stand der Technik

Die Erfindung betrifft eine Bedieneinrichtung für ein Elektrogerät gemäß dem Oberbegriff des Anspruchs 1 sowie ein Elektrogerät.

Bedieneinrichtungen zur Betätigung von Elektrogeräten durch Auflegen oder Ausüben eines leichten Drucks mit einem Finger sind in vielfältiger Form bekannt. Aus der EP 859 467 A und der EP 859 468 A geht ein Funktionsprinzip hervor, nach dem ohne Ausüben eines nennenswerten Drucks bzw. ohne zurückgelegten Bedienweg eine Kapazitätsänderung bei einem kapazitiven Sensorelement herbeigeführt werden kann. Diese kann als Betätigung ausgewertet werden.

Aus der DE 198 11 372 A ist es bekannt, unter einer Blende eines Elektrogeräts, beispielsweise am metallischen Rahmen eines Glaskeramik-Kochfeldes, einen Schalter mit einem Piezoelement vorzusehen. Wird auf den Blendenbereich über dem Piezoelement ein Finger gelegt und ein gewisser Druck ausgeübt, so kann dieser Druck durch das Piezoelement erkannt und als Betätigung ausgewertet werden. Nachteilig hierbei ist jedoch, dass Piezoelemente relativ teuer und teilweise mechanisch empfindlich sind.

Die US 4,359,720, die EP 225748 A2 und die WO 86/065444 zeigen eine Bedieneinrichtung für ein Elektrogerät, bei der durch Drücken auf ein nachgiebiges Bedien-Feld durch Auflegen eines Fingers eine Bedienung erfolgt. Unter dem Bedien-Feld ist ein kapazitives Sensorelement angeordnet mit einer Sensor-Fläche. Durch das Auflegen eines Fingers erfolgt eine Kapazitätsänderung, was als Bedienung zum Auslösen eines Schaltvorgangs ausgewertet werden kann. Dabei werden zwei Sensor-flächen durch das Aufdrücken einander angenähert für die Kapazitätsänderung.

### Aufgabe und Lösung

Der Erfindung liegt die Aufgabe zugrunde, eine eingangs genannte Bedieneinrichtung sowie ein Elektrogerät mit einer solchen Bedieneinrichtung zu schaffen, mit denen Probleme des Standes der Technik vermieden werden können und insbesondere das Einsatzgebiet von kapazitiven Sensorelementen vergrößert wird bei gleichzeitiger Robustheit und Zuverlässigkeit im täglichen Gebrauch.

Gelöst wird diese Aufgabe durch eine Bedieneinrichtung mit den Merkmalen des Anspruchs 1 sowie ein Elektrogerät mit den Merkmalen des Anspruchs 13. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß ist vorgesehen, dass die Bedieneinrichtung ein formveränderliches oder elastisches Bedien-Feld aufweist. Dieses verformt sich durch Drücken bzw. Auflegen eines Fingers mit Druck darauf, wobei als die Bedienung auslösender Druck eine Kraft von etwa der Größenordnung weniger Newton anzusetzen ist. Unter dem Bedien-Feld ist ein kapazitives, vorzugsweise flächiges Sensorelement angeordnet in Form einer elektrisch leitfähigen unteren Sensor-Fläche. Diese bildet eine Kondensatorplatte des kapazitiven Sensorelements. Zwischen Bedien-Feld und Sensorelement bzw. Sensor-Fläche ist eine Dielektrikums-Schicht vorgesehen. Auf der Außenseite bzw. Oberseite ist das Bedien-Feld metallisch bzw. elektrisch leitfähig. Wird wie oben beschrieben auf das Bedien-Feld gedrückt, so nähert sich dieses an die untere Sensorfläche an, die Dielektrikums-Schicht wird dünner und es erfolgt eine Kapazitätsänderung an dem Sensorelement. Diese Kapazitätsänderung wird durch eine entsprechende Auswertung überwacht und ab einer bestimmten Größe, welche in der Regel einem bestimmten Druck und damit einer bestimmten Durchbiegung des Bedien-Feldes entspricht, als gewollte Bedienung ausgewertet.

Der Vorteil der Erfindung liegt vor allen darin, dass ein kapazitives Sensorelement mit den Vorteilen seiner Ansteuerung und Auswertung auch mit einer metallischen Oberfläche des zugehörigen Bedien-Feldes versehen sein kann. Insbesondere ist eine Integration in eine größere metallische Fläche möglich, von der ein nicht abgetrennter Bereich, der jedoch optisch gekennzeichnet sein kann, als Bedien-Feld verwendet wird. Vor allem ist es auch möglich, mehrere unterschiedliche Sensorelemente bzw. Bedien-Felder unter einer durchgängigen metallischen Fläche vorzusehen, ohne dass es zu gegenseitigen Beeinflussungen oder Störungen der Sensorelemente kommt.

Das Bedien-Feld bzw. das Material, aus dem es besteht, ist erfindungsgemäß elektrisch leitfähig und besteht aus einer Materialschicht. Wenn es unterbrechungsfrei ausgebildet ist im Bereich der Bedieneinrichtung oder des einen Bedien-Feldes oder mehrerer Bedien-Felder, kann eine leicht zu reinigende und relativ unempfindliche Oberfläche für die Bedieneinrichtung geschaffen werden. Es kann ein Bedien-Feld aus dünnem Metall, beispielsweise in der Dicke einer Metallfolie mit weniger als 1mm Dicke, insbesondere wenigen 100µm Dicke, ausgebildet sein. Als Material bieten sich grundsätzlich beliebige Metalle an, deren Elastizität für die genannten Anforderungen ausreicht. Insbesondere kann Edelstahl oder ein verchromtes Metall verwendet werden, die aufgrund ihrer Eigenschaften bezüglich Korrosionsbeständigkeit bedeutende Vorteile aufweisen.

Die Dielektrikums-Schicht kann grundsätzlich vielfältig ausgebildet sein. Über die zugehörige Dielektrizitätskonstante kann die Kapazität als Absolutwert am Sensorelement beeinflusst werden. Die hauptsächliche Anforderung an das Dielektrikum ist eine Kompressibilität durch eine eingangs genannte vorteilhafte Betätigungskraft. Es ist insbesondere auch möglich, Luft als Dielektriküms-Schicht vorzusehen. Dazu wird vorteilhaft einfach ein gewisser Abstand zwischen Sensor-Fläche bzw. Sensorelement und Bedien-Feld gelassen. Die Dielektrikums-Schicht kann dünner sein als 1 mm, vorzugsweise im Bereich weniger 100µm liegen.

Bei einem bevorzugten Ausführungsbeispiel der Erfindung sind mehrere Sensorelemente mit jeweils Sensor-Fläche und Bedien-Felder darüber sowie die Dielektrikums-Schichten dazwischen vorgesehen, und zwar nebeneinander angeordnet mit einem gewissen Abstand zueinander. Insbesondere lässt sich dann eine Vereinfachung erreichen, wenn die Bedien-Felder aus einem durchgängigen Material, insbesondere Flachmaterial, wie beispielsweise Metallblech oder Metallfolie, gefertigt sind. Vorteilhaft sind dabei keine Durchbrüche vorgesehen, so dass eine Oberfläche wasserdicht ist und leicht gereinigt werden kann. Unterbrechungen, Ausnehmungen oder dergleichen, beispielsweise um die geringe Dicke für eine Elastizität zum Zusammendrücken zu erreichen, sind bevorzugt an der Unterseite, also zu den Sensorelementen hin, vorgesehen.

Eine Sensor-Fläche kann mit einem gewissen Abstand, insbesondere wenige Millimeter, von einer leitfähigen Fläche umgeben sein, wobei diese eine Massefläche bildet. Bei einer Bedieneinrichtung mit mehreren Sensorelementen nebeneinander ist es von Vorteil, wenn eine gemeinsame und elektrisch verbundene bzw. durchgängige Massefläche vorgesehen ist. Diese kann bei einem Herstellungsverfahren aus derselben Metallschicht wie die Sensorfläche-Flächen herausgebildet sein, wobei sie durch Strukturieren elektrisch getrennt wird. Um die Sensor-Fläche sowie eine eventuelle Massefläche von einer unter Umständen elektrisch leitfähigen Unterseite der Bedien-Felder zu trennen sowie um den Raum zwischen Sensor-Fläche und Bedien-Feld für die Dielektrikums-Schicht zu schaffen, kann eine Abstands-Schicht vorgesehen sein. Diese sollte aus isolierendem Flachmaterial bestehen, welches auch als verarbeitbare Schicht aufgebracht werden kann. Es ist möglich, im Bereich der Sensor-Flächen Aussparungen vorzusehen, um dadurch die Dielektrikums-Schicht aus Luft zu bilden. Alternativ ist es möglich, die Abstands-Schicht aus einem Material mit geeigneter Dielektrizitätskonstante und geeigneter Dicke auszubilden, welches sich dann zwischen Sensor-Fläche und Bedien-Feld befindet und in ausreichendem Maß kompressibel sein sollte.

In weiterer Ausgestaltung der Erfindung ist es möglich, das Bedien-Feld aus einem Flachmaterial oder einer Abdeckung zu schaffen, welche erheblich größer sind als das Bedien-Feld selber. Dadurch ist beispielsweise möglich, eine Bedieneinrichtung mit einem oder mehreren Sensorelementen und somit auch Bedien-Feldern in einer Abdeckung oder Seitenwandung auszubilden, welche beispielsweise zu einem Elektrogerät gehören. Somit kann eine derart ausgestaltete Bedieneinrichtung in eine solche Wandung, insbesondere auch in ein Elektrogerät, integriert werden. Hierbei ist es möglich, die Abdeckung bzw. deren Material im Bereich eines Bedien-Feldes bereichsweise dünner auszubilden als sonst. Hierzu können beispielsweise Material-Ausnehmungen an der Unterseite vorgenommen werden, insbesondere durch materialabtragende Verfahren oder durch verformende Verfahren wie beispielsweise Stanzen oder Prägen. So kann eine Wandung, welche im wesentlichen Halt oder Schutz bietet, bereichsweise dünner ausgeführt sein, um dort die Bedien-Felder einer Bedieneinrichtung anzubringen. Eine Möglichkeit einer solchen Abdeckung ist eine Blende eines Elektrogeräts, beispielsweise eine Frontblende oder ein Rahmen.

Ein erfindungsgemäßes Elektrogerät weist mindestens eine Bedieneinrichtung auf, die einer der vorbeschriebenen Ausführungen entspricht. Vorteilhaft weist das Elektrogerät dazu einen Bedien-Bereich auf, in welchem die Bedieneinrichtung mit einem oder mehreren Bedien-Feldern angeordnet ist. Beispielsweise kann das Elektrogerät ein Kochfeld sein mit einem Seitenteil, welches zumindest an einer Seite als Blende oder auch umlaufend als Rahmen vorgesehen sein kann. Die Bedieneinrichtung ist dabei in dieses Seitenteil bzw. in diesen Rahmen integriert, beispielsweise mit unter dem Seitenteil oder dem Rahmen liegenden Sensorelementen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Zwei Ausführungsbeispiele der Erfindung sind in den Zeichnungen schematisch dargestellt und werden im folgenden näher erläutert. In den Zeichnungen zeigen:
- Fig. 1: einen Schnitt durch einen Schichtaufbau einer erfindungsgemäßen Bedieneinrichtung,
- Fig. 2: eine Draufsicht auf eine Schicht der Bedieneinrichtung aus Fig. 1 mit mehreren nebeneinander angeordneten Sensorelementen,
- Fig. 3: eine Draufsicht auf die Isolatorschicht und
- Fig. 4: eine Schrägansicht eines Kochfeldes, bei dem im Rahmen einer Bedieneinrichtung ähnlich Fig. 1 integriert ist.

### Detaillierte Beschreibung der Ausführungsbeispiele

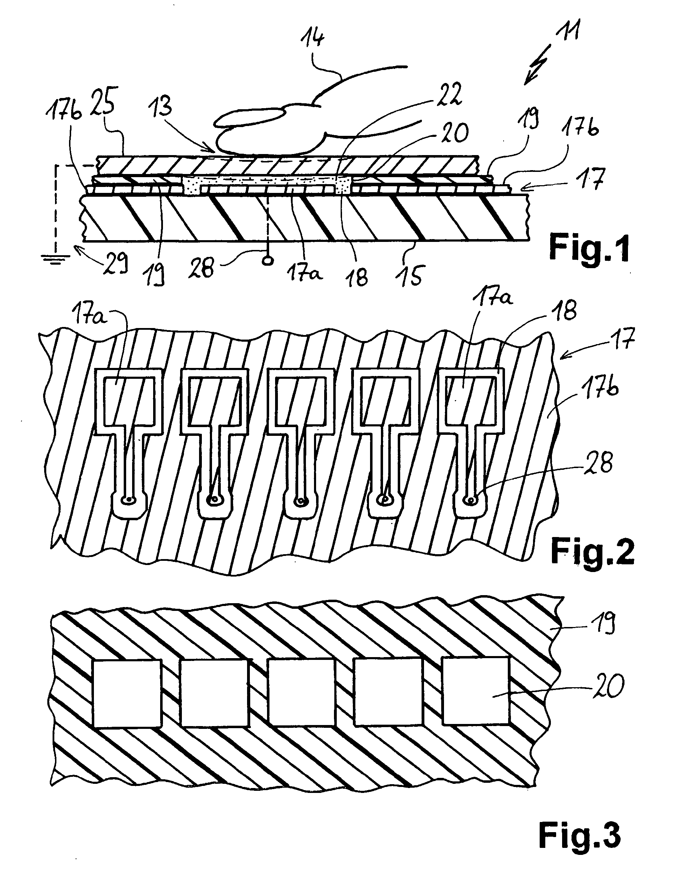

In Fig. 1 ist eine Bedieneinrichtung 11 schematisch im Schnitt dargestellt, wobei sie ein Bedien-Feld 13 aufweist, auf welches ein Finger 14 gelegt wird mit leichtem Druck zur Bedienung bzw. Auslösung einer Bedienung. Das Bedien-Feld 13 kann an seiner Oberseite optisch erkennbare Markierungen tragen wie Aufschriften, Aufdrucke oder dergleichen. Es kann ebenso eine entsprechende Strukturierung der Oberfläche vorgesehen sein, beispielsweise durch Symbole mittels Vertiefungen oder Erhöhungen.

Die Bedieneinrichtung 11 weist einen Schichtaufbau auf, der im folgenden erläutert wird. Auf einer Leiterplatte 15 als Träger ist eine Metallschicht 17 aufgebracht. Die Metallschicht 17 ist unterteilt in Sensorelemente 17a einerseits, deren flächige Form mit Anschluss aus der Draufsicht in Fig. 2 zu erkennen ist und die die oben genannten Sensor-Flächen bilden. Anstelle quadratischer Form der Sensorelemente 17a können selbstverständlich auch runde oder ovale sowie langgestreckte Formen verwendet werden. Die Sensorelemente 17a sind durch Rahmen-Ausschnitte 18, deren Ausbildung ebenfalls in Fig. 2 zu erkennen ist, aus der Metallschicht 17 herausgearbeitet. Die umgebende Metallfläche 17b bildet eine Art Massefläche. Die Metallschicht 17 kann beispielsweise als Kupferschicht nach üblichen Verfahren auf die Leiterplatte 15 aufgebracht werden. Ebenso kann die Strukturierung auf bekannte Art erfolgen.

Auf der Metallschicht 17 ist eine Isolatorschicht 19 aufgebracht mit Aussparungen 20, die von der Form her den Sensorelementen 17a entsprechen und etwas größer sind, so dass sie die Sensorelemente so umgeben wie die Rahmen-Ausschnitte 18. Die Isolatorschicht 19 kann eine Kunststoff-Folie sein, beispielsweise eine Polyesterfolie. Sie kann ein- oder beidseitig selbstklebend sein, um den Aufbau leichter herzustellen.

Auf der Isolatorschicht 19 wiederum ist eine Metallfolie 25 aufgebracht. Diese kann beispielsweise eine Edelstahlfolie, ein dünnes Edelstahlblech oder dergleichen sein, welche insbesondere bei freiliegender Oberfläche, wodurch das Bedien-Feld 13 gebildet wird, vorteilhaft ist in der praktischen Anwendung hinsichtlich Reinigungs- und Pflegebedarf.

Die Metallfolie 25 ist zumindest im Bereich der Bedieneinrichtung 11 oder der Bedien-Felder 13 durchgängig mit gleicher Dicke. In alternativen Ausführungen kann auch eine dickere Metallschicht bzw. Metallplatte verwendet werden, welche über den Bedien-Feldern 13 ausgedünnt ist.

Zwischen Metallfolie 25 und Sensorelement 17a wird ein Zwischenraum gebildet, der mit einer Luftschicht 22 gefüllt ist. Dieser Raum ist durch die Punktierung als Luftfüllung dargestellt. Die enthaltende Luftschicht 22 bildet ein Dielektrikum zwischen metallischem Bedien-Feld 13 und Sensorelement 17a. Dieses wird nachfolgend noch genauer beschrieben hinsichtlich der Funktion. Anstelle einer Luftschicht 22 als Dielektrikum kann auch ein anderes Dielektrikum verwendet werden, solange es kompressibel ist bzw. zusammengedrückt werden kann, um das Bedien-Feld 13 näher an das Sensorelement 17a zu bringen. Diese Durchbiegung des Bedien-Feldes 13 ist im Bereich des Fingers 14 durch die nach unten gewölbte Strichlierung verdeutlicht.

An das Sensorelement 17a führt ein Anschluss 28, der von den nach unten ragenden Enden der Sensorelemente 17 gemäß Fig. 2 abgeht, beispielsweise zu einer Steuerung bzw. Auswertung der Bedieneinrichtung 11. Die obenliegende Metallfolie 25 kann, wie gestrichelt dargestellt ist, an Erde 29 angeschlossen sein. Darauf kann jedoch auch verzichtet werden, wobei dann nur eine kapazitive Ankopplung an das Sensorelement 17a bzw. an die umgebende Fläche 17b der Metallschicht 17 vorgesehen ist.

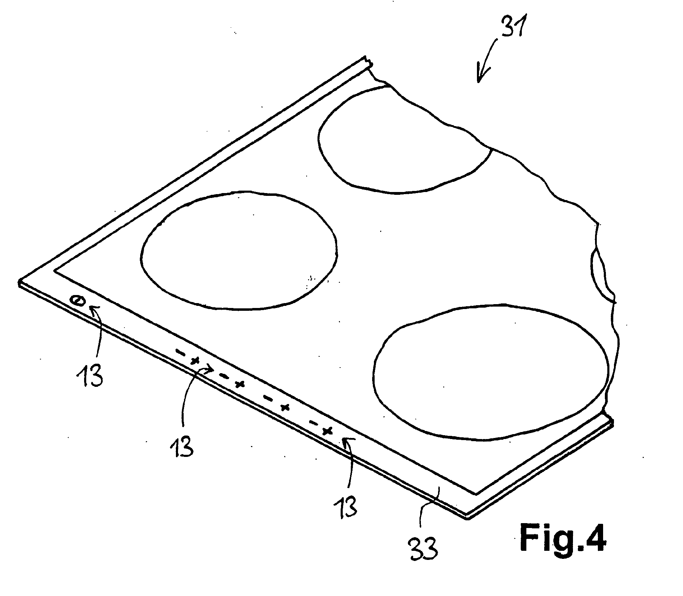

In Fig. 4 ist ein Kochfeld 31 dargestellt, insbesondere ein sogenanntes Glaskeramik-Kochfeld. Dieses weist auf an sich übliche Art einen umlaufenden Kochfeld-Rahmen 33 auf, der an seiner linken unteren Seite als zu einem Bediener hin weisende Vorderseite ausgebildet ist. Der Rahmen 33 weist verschiedene Bedien-Felder 13 auf, und zwar ganz links in Form eines EIN-/AUS Schalters sowie wie im Mittelbereich als Schalter zur Leistungseinstellung der einzelnen Kochstellen, welche kreisförmig schematisch dargestellt sind. Durch Druck auf die Bedien-Felder 13 kann die jeweils zugeordnete Funktion ausgelöst werden. Vom Aufbau her befindet sich unter dem Kochfeld-Rahmen 33 eine Bedieneinrichtung ähnlich derjenigen aus der Fig. 1. Dabei kann die Oberfläche des Kochfeld-Rahmens 33 durchgängig aus einer Metallschicht oder Metallplatte bzw. Metallfolie gebildet sein, welche der Metallfolie 25 aus Fig. 1 entspricht. Da nur unterhalb der Bedien-Felder 13 der Schichtaufbau gemäß Fig. 1 vorzusehen ist, kann das Metall im sonstigen Bereich des Kochfeld-Rahmens 33 sozusagen massiv unterfüttert sein.

Alternativ kann der Kochfeld-Rahmen aus einem gegebenenfalls mehrere mm starken metallischen Flachmaterial bestehen. Dieses ist beispielsweise im Bereich der Bedien-Felder 13 oder einer dazugehörigen Bedieneinrichtung von unten her so ausgedünnt, dass in diesen ausgedünnten Bereichen der Schichtaufbau gemäß Fig. 1 untergebracht werden kann. Als Alternative zu einer Ausdünnung einer dickeren Metallschicht von unten kann auch eine Ausdünnung von oben vorgesehen sein. In diesem Fall könnte eine dadurch entstehende Mulde als Strukturierung für ein punktgenaues Anlegen eines Fingers oder dergleichen verwendet werden.

Zu den Abmessungen in der Fig. 1 ist zu bemerken, dass diese variieren können. Vorteilhafte Dicken der einzelnen Schichten sind für die Leiterplatte 15 beliebig. Die Metallschicht 17 kann ebenfalls beliebig dick sein, beispielsweise im Bereich von 0,1 mm, wie üblicherweise für kupferbeschichtete Leiterplatten oder dergleichen. Die Isolatorschicht kann ebenfalls 0,1 mm dick sein. Die darüber liegende Metallfolie 25 ist in Versuchen mit einer Dicke von 0,2mm als Edelstahlfolie eingesetzt worden, was verwertbare Resultate ergibt. Die in Fig. 1 übertrieben stark dargestellte Durchbiegung mit Strichlierung der Metallfolie 25 kann im µm-Bereich liegen, beispielsweise 10µm oder weniger. Bei einem Versuchsaufbau mit einer 0,2mm starken Edelstahlfolie als Metallfolie 25 hat ein Gewicht von 230 Gramm bereits eine solche Durchbiegung verursacht, dass eine Kapazitätsänderung von 18% an dem Sensorelement 17a festgestellt werden konnte. Die Fläche eines Sensorelements 17a bzw. eines Bedien-Feldes liegt vorteilhaft bei ca. 1 bis 3cm pro Seite. So ist eine relativ gut definierte Auflagefläche samt resultierender Durchbiegung bei Auflegen eines Fingers 14 zu erreichen.

### Funktion

Grundsätzlich beruht die Bedieneinrichtung 11 gemäß der Erfindung auf der Auswertung eines kapazitiven Sensorelements 17a, wobei durch die Bedienung eine Änderung der Kapazität erfolgt. Ein Beispiel für eine Auswerteschaltung solcher kapazitiver Sensorelemente; allerdings bei einem etwas anders aufgebauten Sensorelement, ist aus der EP 859 468 A zu entnehmen. Diese Auswerteschaltung kann grundsätzlich auch hier verwendet werden.

Durch Auflegen eines Fingers 14 auf ein Bedien-Feld 13 erfolgt aufgrund der Druckkraft eine gewisse Durchbiegung des Bedien-Feldes bzw. der zugeordneten Metallfolie 25. Dadurch wird der Abstand zwischen dem Sensorelement 17a, welches funktional eine Fläche eines Kondensators darstellt, und der darüber verlaufenden Metallfolie 25 verändert. Dieses führt zu einer deutlichen Kapazitätsänderung am Sensorelement 17a. Diese Kapazitätsänderung kann erfasst und ausgewertet werden. Durch ein dazwischenliegendes Dielektrikum 22 kann der Effekt durch die Erhöhung der Kapazität verstärkt werden und somit die Auswertbarkeit verbessert werden.

Ein weiterer Vorteil der Erfassung der Kapazitätsänderung als relative Änderung und nicht nur der absoluten Größe ist derjenige, dass abhängig von eventuell mit der Zeit erfolgender Durchbiegung der Metallfolie 25 nach unten und daraus resultierender Änderung der absoluten Kapazität keine Messwertverfälschungen auftreten.

Somit kann mit der Erfindung eine Bedieneinrichtung geschaffen werden, welche einerseits ein kapazitives Sensorelement bzw. ein kapazitives Funktionsprinzip aufweist. Gleichzeitig können damit kombiniert Metalloberflächen, insbesondere Edelstahloberflächen, für die Bedieneinrichtung auch an den Bedien-Feldern verwendet werden. Diese sind aus praktischen Gründen sehr vorteilhaft und finden sich in vielerlei Elektrogeräten wieder, insbesondere auch Haushaltsgeräten. Bereits ein geringer Druck mit einem Finger reicht aus zur Bedienung. Ebenso reichen sehr kurze Bedienwege aus, welche für mechanische Schalter als Schaltweg nicht ausreichen würden.

## Patentansprüche

1. Bedieneinrichtung für ein Elektrogerät, vorzugsweise ein Haushaltsgerät (31), wobei die Bedienung durch Drücken auf ein formveränderliches oder elastisches Bedien-Feld (13) mit einem kapazitiven Sensorelement darunter erfolgt, wobei das Sensorelement eine elektrisch leitfähige untere Sensor-Fläche (17a) als eine Kondensatorplatte aufweist, mit dem Bedien-Feld (13) darüber sowie einer Dielektrikums-Schicht (22) dazwischen, wobei das Bedien-Feld (13) zumindest auf seiner Außenseite metallisch bzw. elektrisch leitfähig ist und durch Drücken eine Annäherung des Bedien-Felds an die untere Sensor- Fläche (17a) mit Kapazitätsänderung erfolgt, **dadurch gekennzeichnet, dass** das Bedien-Feld (13) durchgängig elektrisch leitfähig ist, und aus einer einzigen Materialschicht (25) besteht

2. Bedieneinrichtung nach Anspruch 1, **dadurch gekennzeichnet, dass** das Bedien-Feld (13) unterbrechungsfrei ist im Bereich der Bedieneinrichtung (11) oder des Bedien-Feldes.

3. Bedieneinrichtung nach Anspruch 1 oder 2, **dadurch gekennzeichnet, dass** das Bedien-Feld (13) aus dünnem Metall, wie einer Metallfolie (25), besteht, vorzugsweise aus Edelstahl.

4. Bedieneinrichtung nach einem der vorhergehenden Ansprüche, **dadurch gekennzeichnet, dass** die Dielektrikums-Schicht Luft aufweist, insbesondere ausschließlich eine Luftschicht (22) ist.

5. Bedieneinrichtung nach einem der vorhergehenden Ansprüche, **dadurch gekennzeichnet, dass** die Dielektrikums-Schicht (22) dünner ist als 1 mm, vorzugsweise ca. 100µm dick ist, wobei insbesondere das Bedien-Feld (13) dünner ist als 1 mm, insbesondere ca. 0,2mm dick.

6. Bedieneinrichtung nach einem der vorhergehenden Ansprüche, **dadurch gekennzeichnet, dass** mehrere Sensorelemente mit jeweils Sensor-Fläche (17a) und Bedien-Feld (13) darüber sowie Dielektrikums-Schicht (22) dazwischen nebeneinander angeordnet sind, wobei vorzugsweise die Bedien-Felder aus einem durchgängigen Flachmaterial gefertigt sind, insbesondere einer Metallfolie (17).

7. Bedieneinrichtung nach einem der vorhergehenden Ansprüche, **dadurch gekennzeichnet, dass** eine Sensor-Fläche (17a) mit Abstand von einer leitfähigen Fläche umgeben ist welche eine Massefläche (17b) bildet, wobei insbesondere mehrere Sensor-Flächen nebeneinander angeordnet sind und jeweils von einer gemeinsamen, durchgängigen Massefläche umgeben sind.

8. Bedieneinrichtung nach Anspruch 7, **dadurch gekennzeichnet, dass** die Sensor-Flächen (17a), insbesondere als Metallschichten, auf einem Träger (15) angeordnet sind, wobei eine die Sensor-Flächen umgebende Massefläche (17b) aus derselben Metallschicht durch Strukturieren herausgearbeitet ist.

9. Bedieneinrichtung nach Anspruch 8, **dadurch gekennzeichnet, dass** auf einer die Sensor-Flächen (17a) und Masseflächen (17b) bildenden Schicht (17) eine Abstands-Schicht, insbesondere aus isolierendem Flachmaterial (19), aufgebracht ist, welche Aussparungen (20) im Bereich der Sensor-Flächen (17a) aufweist, wobei auf der isolierenden Flachmaterialschicht die Bedien-Felder (13) angeordnet sind und die Dielektrikums-Schicht (22) durch den Abstand zwischen Sensor-Fläche und Bedien-Feld in den Aussparungen (20) des isolierenden Flachmaterials (19) gebildet ist.

10. Bedieneinrichtung nach einem der Ansprüche 1 bis 8, **dadurch gekennzeichnet, dass** zwischen Sensor-Fläche (17a) und Bedien-Feld (13) ein elastisches isolierendes Flachmaterial angeordnet ist, welches durch Drücken auf das Bedien-Feld zusammengedrückt wird.

11. Bedieneinrichtung nach einem der vorhergehenden Ansprüche, **dadurch gekennzeichnet, dass** das Bedien-Feld (13) von einem Flachmaterial (25) oder einer Abdeckung gebildet wird, welche erheblich größer ist und erheblich über seine Größe hinaus verläuft, wobei insbesondere die Abdeckung im Bereich des Bedien-Feldes oder der Bedieneinrichtung (11) bereichsweise dünner ausgebildet ist, vorzugsweise durch Material-Ausnehmungen an der Unterseite.

12. Bedieneinrichtung nach einem der vorhergehenden Ansprüche, **dadurch gekennzeichnet, dass** sie eine einem Bediener zugewandte Außenfläche aufweist mit einer zumindest im Bereich von Bedien-Feldern (13) geschlossenen Oberfläche in Form einer Blende oder eines Rahmens (33), wobei aus der Blende oder dem Rahmen (33) die Bedien-Felder herausgearbeitet sind bzw. die Blende oder der Rahmen diese bilden.

13. Elektrogerät, insbesondere Haushaltsgerät (31), **dadurch gekennzeichnet, dass** es eine Bedieneinrichtung (11) nach einem der vorhergehenden Ansprüche aufweist, vorzugsweise in einem Bedien-Bereich.

14. Elektrogerät nach Anspruch 13, **dadurch gekennzeichnet, dass** es ein Kochfeld (31) ist mit einem umlaufenden Rahmen (33) und dass die Bedieneinrichtung (11) in den Rahmen integriert ist, wobei vorzugsweise ein Bedien-Feld (13) von dem Rahmen (33) gebildet ist bzw. daraus herausgearbeitet ist.

## Claims

1. Operating device for an electrical appliance, preferably a domestic appliance (31), operation taking place by pressure on a shape-variable or elastic operating field (13) with a capacitive sensor element below it, the sensor element having an electrically conductive, lower sensor surface (17a) as a capacitor plate with the operating field (13) above it and a dielectric layer (22) between the same, at least on its outside, the operating field (13) is metallic or electrically conductive and by pressure the operating field approaches the lower sensor surface (17a) with a capacitance change, **characterized in that** the operating field (13) is electrically conductive throughout and is in particular formed from a single material layer (25).

2. Operating device according to claim 1, **characterized in that** the operating field (13) is uninterrupted in the vicinity of the operating device (11) or operating field.

3. Operating device according to claim 2, **characterized in that** the operating field (13) is made from thin metal, such as a metal foil (25) and is preferably of high-grade steel.

4. Operating device according to one of the preceding claims, **characterized in that** the dielectric layer has air and is in particular exclusively an air layer (22).

5. Operating device according to one of the preceding claims, **characterized in that** the dielectric layer (22) is thinner than 1 mm and is preferably approximately 100 µm thick and in particular the operating field (13) is thinner than 1 mm and in particular approximately 0.2 mm thick.

6. Operating device according to one of the preceding claims, **characterized in that** several sensor elements with in each case a sensor surface (17a) and operating field (13) above the same and a dielectric layer (22) between the same are juxtaposed and preferably the operating fields are made from a flat material throughout and in particular a metal foil (17).

7. Operating device according to one of the preceding claims, **characterized in that** a sensor surface (17a) is surrounded in spaced manner by a conductive surface forming an earth surface (17b) and in particular several sensor surfaces are juxtaposed and in each case surrounded by a common, continuous earth surface.

8. Operating device according to claim 7, **characterized in that** the sensor surfaces (17a), particularly as metal coatings, are placed on a support (15), an earth surface (17b) surrounding the sensor surfaces being worked from the same metal coating by structuring.

9. Operating device according to claim 8, **characterized in that** a spacing layer, particularly of insulating flat material (19) is applied to a layer (17) forming the sensor surfaces (17a) and earth surfaces (17b) and has recesses (20) in the vicinity of sensor surfaces (17a), the operating fields (13) being located on the insulating flat material layer and the dielectric layer (22) being formed in the recesses (20) of insulating flat material (19) through the spacing between the sensor surface and operating field.

10. Operating device according to one of the claims 1 to 8, **characterized in that** an elastic, insulating flat material is placed between sensor surface (17a) and operating field (13) and is compressed by pressure on the operating field.

11. Operating device according to one of the preceding claims, **characterized in that** the operating field (13) is formed by a flat material (25) or cover, which is significantly larger and extends significantly beyond its size and in particular, in the vicinity of the operating field or operating device (11), the cover is zonally made thinner, preferably as a result of material recesses on the underside.

12. Operating device according to one of the preceding claims, **characterized in that** it has an outer face facing a user with, at least in the vicinity of the operating fields (13), a closed surface in the form of a panel or frame (33), the operating fields being worked out of the panel or frame (33) or said panel or said frame forming said operating fields.

13. Electrical appliance, particularly domestic appliance (31), **characterized in that** it has an operating device (11) according to one of the preceding claims, preferably in an operating area.

14. Electrical appliance according to claim 13, **characterized in that** it is a hob (31) with an all-round frame (33) and that the operating device (11) is integrated into the frame and preferably an operating field (13) is formed by or worked out of the frame (33).

## Revendications

1. Dispositif de commande pour un appareil électrique, de préférence un appareil ménager (31), où la commande a lieu par une pression sur un champ de service (13) déformable ou élastique au-dessous duquel se trouve un élément de détection capacitif, où l'élément de détection présente une surface de détection inférieure (17a) électriquement conductible en tant que plaque de condensateur, avec un champ de service (13) situé au-dessus ainsi qu'une couche diélectrique (22) intermédiaire, sachant que le champ de service (13) est métallique ou encore électriquement conductible au moins de son côté extérieur et qu'en créant une pression, on effectue un rapprochement du champ de service à la surface de détection inférieure (17a) ce qui provoque des changements de capacité, **caractérisé en ce que** la totalité du champ de service (13) est électriquement conductible et qu'il est constitué d'une seule couche de matériau (25).

2. Dispositif de commande d'après la revendication 1, **caractérisé en ce que** le champ de service (13) ne présente aucune interruption dans le domaine du dispositif de commande (11) ou du champ de service.

3. Dispositif de commande d'après la revendication 1 ou 2, **caractérisé en ce que** le champ de service (13) est composé de métal mince, comme d'une feuille métallique (25), de préférence d'acier inoxydable.

4. Dispositif de commande d'après une des revendications précédentes, **caractérisé en ce que** la couche diélectrique présente de l'air, en n'étant de préférence qu'une couche d'air (22).

5. Dispositif de commande d'après une des revendications précédentes, **caractérisé en ce que** la couche diélectrique (22) présente une épaisseur inférieure à 1 mm, de préférence d'à peu près 100µm, sachant que notamment le champ de service (13) présente une épaisseur inférieure à 1 mm, notamment d'à peu près 0,2 mm.

6. Dispositif de commande d'après une des revendications précédentes, **caractérisé en ce que** plusieurs éléments de détection, qui présentent respectivement une surface de détection (17a) et au-dessus un champ de service (13) ainsi qu'une couche diélectrique (22) intermédiaire, sont disposés les uns à côté des autres, sachant que de préférence les champs de service sont fabriqués à partir d'un matériau plat continu, notamment d'une feuille métallique (17).

7. Dispositif de commande d'après une des revendications précédentes, **caractérisé en ce qu'**une surface de détection (17a) est entourée à une certaine distance d'une surface conductible, qui constitue une surface de mise à la masse (17b), sachant que notamment plusieurs surfaces de détection sont disposées les unes à côté des autres et que celles-ci sont entourées respectivement d'une surface de mise à la masse collective et continue.

8. Dispositif de commande d'après la revendication 7, **caractérisé en ce que** les surfaces de détection (17a) sont disposées notamment en tant que couches métalliques sur un support (15), sachant qu'une surface de mise à la masse (17b) entourant les surfaces de détection est réalisée à partir de la même couche métallique par structuration.

9. Dispositif de commande d'après la revendication 8, **caractérisé en ce que** sur une couche (17) constituée par les surfaces de détection (17a) et les surfaces de mise à la masse (17b) on applique une couche de distancement, notamment d'un matériau plat isolant (19), laquelle présente des évidements (20) dans le domaine des surfaces de détection (17a), sachant que sur la couche en matériau plat isolant sont disposées les champs de service (13) et que la couche diélectrique (22) est formée au moyen de l'écart entre la surface de détection et le champ de service dans les évidements (20) du matériau plat isolant (19).

10. Dispositif de commande d'après une des revendications de 1 à 8, **caractérisé en ce qu'**entre la surface de détection (17a) et le champ de service (13) est disposé un matériau plat isolant élastique, lequel devient plus mince par une pression sur un champ de service.

11. Dispositif de commande d'après une des revendications précédentes, **caractérisé en ce que** le champ de service (13) est constitué d'un matériau plat (25) ou d'un recouvrement, dont la dimension dépasse considérablement la dimension du champ de service, sachant que notamment le recouvrement est réalisé de manière à être plus mince dans certaines zones du domaine du champ de service ou du dispositif de commande (11), de préférence par des évidements de matériau à la face inférieure.

12. Dispositif de commande d'après une des revendications précédentes, **caractérisé en ce qu'**il présente une face extérieure orientée vers l'utilisateur avec une surface fermée au moins dans le domaine des champs de service (13) sous forme d'un cadre ou d'une bordure (33), sachant que les champs de service sont fabriqués à partir du cadre ou de la bordure (33) ou encore que le cadre ou la bordure (33) forment les champs de service.

13. Appareil électrique, notamment appareil ménager (31), **caractérisé en ce qu'**il présente un dispositif de commande (11) d'après une des revendications précédentes, de préférence dans une zone de service.

14. Appareil électrique d'après la revendication 13, **caractérisé en ce qu'**il s'agit d'un champ de cuisson (31) avec une bordure (33) qui s'étend tout autour et **en ce que** le dispositif de commande (11) est intégré dans une bordure, sachant que de préférence un champ de service (13) est formé ou encore fabriqué à partir de la bordure (33).
